# EUROPÄISCHE PATENTSCHRIFT

(11) **EP 1 283 571 B1**
(45) Veröffentlichungstag und Bekanntmachung des Hinweises auf die Patenterteilung: **14.01.2015**
(21) Anmeldenummer: 01118970.1
(22) Anmeldetag: 06.08.2001
(51) Int. Cl.: H01S 5/12, H01S 5/125, H01S 5/22

(54) **Laser mit schwach gekoppeltem Gitterbereich**
Laser with weakly coupled grating
Laser avec réseau à couplage faible

(43) Veröffentlichungstag der Anmeldung: 12.02.2003
(73) Patentinhaber: nanoplus GmbH Nanosystems and Technologies, 97218 Gerbrunn (DE)
(72) Erfinder: Reithmaier,Johann Peter, 97078 Würzburg (DE); Bach,Lars, 01109 Dresden-Klotzsche (DE)

(56) Entgegenhaltungen:
- US-A- 4 826 282
- KAMP M ET AL: "Lateral coupling - a material independent way to complex coupled DFB lasers" OPTICAL MATERIALS, ELSEVIER SCIENCE PUBLISHERS B.V. AMSTERDAM, NL, Bd. 17, Nr. 1-2, Juni 2001 (2001-06), Seiten 19-25, XP004254783 ISSN: 0925-3467
- PATENT ABSTRACTS OF JAPAN vol. 010, no. 170 (E-412), 17. Juni 1986 (1986-06-17) & JP 61 023383 A (MITSUBISHI DENKI KK), 31. Januar 1986 (1986-01-31)
- PATENT ABSTRACTS OF JAPAN vol. 016, no. 008 (E-1152), 10. Januar 1992 (1992-01-10) & JP 03 229481 A (NIPPON TELEGR & TELEPH CORP), 11. Oktober 1991 (1991-10-11)
- KOENIG H ET AL: "COMPLEX COUPLED 1.55 MUM DFB-LASERS BASED ON FOCUSED ION BEAM ENHANCED WET CHEMICAL ETCHING AND QUANTUM WELL INTERMIXING" 1999 11TH. INTERNATIONAL CONFERENCE ON INDIUM PHOSPHIDE AND RELATED MATERIALS. CONFERENCE PROCEEDINGS. IPRM DAVOS, MAY 16 - 20, 1999, INTERNATIONAL CONFERENCE ON INDIUM PHOSPHIDE AND RELATED MATERIALS, NEW YORK, NY: IEEE, US, Bd. CONF. 11, 16. Mai 1999 (1999-05-16), Seiten 29-32, XP000931403 ISBN: 0-7803-5563-6
- KOJI KUDO ET AL: "LINEWIDTH REDUCTION OF DSM LASERS DUE TO EFFECTS OF COMPOSITE CAVITY AND DISTRIBUTED REFLECTORS" IEEE JOURNAL OF QUANTUM ELECTRONICS, IEEE INC. NEW YORK, US, Bd. 29, Nr. 6, 1. Juni 1993 (1993-06-01), Seiten 1769-1781, XP000397614 ISSN: 0018-9197
- PATENT ABSTRACTS OF JAPAN vol. 009, no. 295 (E-360), 21. November 1985 (1985-11-21) & JP 60 133777 A (NIPPON DENSHIN DENWA KOSHA), 16. Juli 1985 (1985-07-16)
- ROH S D ET AL: "Dual-Wavelength InGaAs-GaAs Ridge Waveguide Distributed Bragg Reflector Lasers with Tunable Mode Separation", IEEE PHOTONICS TECHNOLOGY LETTERS, IEEE SERVICE CENTER, PISCATAWAY, NJ, US, vol. 12, no. 10, 1 October 2000 (2000-10-01), XP011047353, ISSN: 1041-1135

## Beschreibung

Die vorliegende Erfindung betrifft einen Halbleiterlaser zur Erzeugung einer Lichtwelle, mit einem Halbleitersubstrat, einer auf dem Halbleitersubstrat angeordneten Laserschicht, einem zumindest teilweise benachbart zur Laserschicht angeordneten Wellenleiterbereich und einer streifenförmig ausgebildeten Gitterstruktur. Des weiteren betrifft die vorliegende Erfindung ein Verfahren zur vorteilhaften Herstellung eines derartigen Halbleiterlasers.

Laserdioden haben im Laufe der vergangenen Jahre zunehmend Eingang in unterschiedlichste Bereiche der Technik gefunden. Auch die Telekommunikationstechnik bedient sich in zunehmendem Maße solcher Laserdioden, um Telefongespräche und Daten zu übertragen Das von den Laserdioden emittierte Licht wird über Glasfaserleitungen zu einem Empfänger übertragen. Eine solche Übertragung zeichnet sich durch eine hohe Übertragungsqualität und eine sehr hohe mögliche Datenübertragungsrate aus. Während ursprünglich bei Glasfasern nur eine Übertragung bei einer Wellenlänge erfolgte, d.h., dass lediglich das Licht einer Laserdiode mit einer einzigen Wellenlänge übertragen wurde, wurde es in den letzten Jahren zunehmend üblicher, bei der Übertragung mit Glasfasern mehrere Wellenlängen gleichzeitig zu verwenden, so dass mehrere Wellenlängen gleichzeitig zur Übertragung beitragen (Wellenlängenmultiplexing). Bei gleichzeitiger Verwendung mehrerer Wellenlängen können somit mit einer einzigen Glasfaser deutlich mehr Gespräche bzw. Daten pro Zeiteinheit übertragen werden.

Nach dem derzeitigen Stand der Technik wird bei Übertragungen unter Verwendung mehrerer Wellenlängen in der Regel das von mehreren Laserdioden emittierte Licht über entsprechende Vorrichtungen zusammengeführt und gemeinsam über eine Glasfaser übertragen. Die einzelnen Laser emittieren dabei Laserlicht mit unterschiedlichen Wellenlängen. Um eine hohe Datenübertragungsqualität und einen möglichst großen Datendurchsatz zu gewährleisten, ist es dabei erforderlich, dass eine einzelne Laserdiode Idealerweise ausschließlich bei ihrer Soll-Frequenz Licht emittiert. In der Praxis ist es jedoch unvermeidbar, dass ein bestimmter Anteil der emittierten Lichtleistung auch bei anderen Wellenlängen emittiert wird. Die beiden wichtigsten Kenngrößen, die diesbezüglich die Qualität der Laserdioden beschreiben, sind die sog. Monomodestabilität, sowie die Seitenmodenunterdrückung. Die Monomodestabilität beschreibt dabei Abweichungen der emittierten Lichtwellenlänge bei unterschiedlichen Betriebsbedingungen (Temperatur, angelegte Spannung, usw.) bzw. unterschiedlichem Alter der Laserdiode. Die Seitenmodenunterdrückung beschreibt das Verhältnis der Lichtleistungen bei der stärksten emittierten Wellenlänge im Verhältnis zur zweitstärksten emittierten Wellenlänge. Je größer die Seitenmodenunterdrückung ist, desto weniger Licht wird folglich in unerwünschten Frequenzbereichen ausgesandt.

Bekannte Laserdioden verfügen über eine aktive Verstärkerschicht, in denen eine Lichtwelle durch stimulierte Emission verstärkt wird. Insbesondere bei Halbleiterlasern ist diese Verstärkung nur wenig frequenzselektiv, so dass eine Verstärkung in einem breiten Frequenzbereich erfolgt. Daher ist es erforderlich, zusätzliche Maßnahmen zu ergreifen, um eine Frequenzselektion zu bewirken, so dass im wesentlichen nur bei einer einzigen Wellenlänge Licht ausgesandt wird. Dies wird üblicherweise durch periodische Gitterstrukturen erreicht. Durch eine Kopplung zwischen der periodischen Gitterstruktur und der Lichtwelle werden durch Interferenzeffekte von der Soll-Wellenlänge abweichende Wellenlängen stark gedämpft, so dass die Laserdiode im wesentlichen nur noch Licht der Soll-Wellenlänge verstärkt und emittiert.

Derzeit wird allgemein davon ausgegangen, dass eine besonders effektive Wellenlängenselektion und damit eine hohe Seitenmodenunterdrückung nur dann zu erreichen ist, wenn eine besonders starke Kopplung zwischen Lichtwelle und periodischer Gitterstruktur vorhanden ist. Dies betrifft sowohl theoretische Abhandlungen, als auch experimentelle Untersuchungen. Üblicherweise wird von einem Kopplungskoeffizienten κ ausgegangen, der im Bereich von K = 100 cm⁻¹ bis K = 300 cm⁻¹ oder höher liegen sollte. So wird beispielsweise in der theoretischen Abhandlung "Mode Selectivity of Distributed Bragg-Reflector Laser with Optical Loss in Corrugated Waveguide" von Masahiro Okuda et al., erschienen in Japan Journal of Applied Physics, Volume 14, 1975, No. 11, Seite 1859, festgestellt, dass die Seitenmodenunterdrückung mit zunehmender Kopplungskonstante ansteigt. Auch in experimentellen Arbeiten wird von der Gültigkeit dieser Annahme ausgegangen. So wird beispielsweise im Artikel "Single and Tunable Dual-Wavelength Operation of an InGaAs-GaAs Ridge Waveguide Distributed Bragg Reflector Laser" von Roh et al. in IEEE Transactions on Photonic Letters, Volume 12, No. 1, Januar 2000, Seite 16, oder im Artikel "Dual-wavelength InGasAs-GaAs Ridge Waveguide Distributed Bragg Reflector lasers with tunable mode separation" IEEE Photonics Technology Letters vol. 12, no. 10 oct 20000 pages 1307-1309 die gute Seitenmodenunterdrückung der dort beschriebe nen Laserdiode auf den relativ hohen Wert des Kopplungskoeffizienten K zurückgeführt.

Aufgabe der vorliegenden Erfindung ist es, einen Halbleiterlaser vorzuschlagen, der im Vergleich zu bisherigen Halbleiterlasern verbesserte

Bauteileigenschaften aufweist, wie insbesondere eine verbesserte Seitenmodenunterdrückung bzw. eine verbesserte Monomodestabilität, und dennoch kostengünstig in der Herstellung und im Betrieb ist. Des weiteren liegt der Erfindung die Aufgabe zugrunde, ein besonders vorteilhaftes und kostengünstiges Verfahren zur Herstellung eines solchen Halbleiterlasers vorzuschlagen.

Ein Halbleiterlaser mit den Merkmalen des Anspruchs 1 bzw. ein Verfahren mit den in Anspruch 18 genannten Verfahrensschritten löst diese Aufgaben.

Die Aufgabe wird dadurch gelöst, dass bei einem Halbleiterlaser gemäß der vorliegenden Erfindung Laserschicht, Wellenleiterbereich und Gitterstruktur derart aufeinander angepasst sind, dass eine nur schwache Kopplung zwischen Lichtwelle und Gitterstruktur erfolgt und somit eine größere Anzahl an Gitterstrukturelementen mit der Lichtwelle in Wechselwirkung tritt. Anstatt also, wie bisher, eine relativ starke Kopplung zwischen Lichtwelle und Gitterstruktur vorzusehen, wird ganz im Gegenteil durch entsprechende konstruktive Maßnahmen eine deutlich niedrigere Kopplung zwischen Lichtwelle und Gitterstruktur vorgesehen. Durch die nur schwache Kopplung werden die Interferenzeffekte der Lichtwelle von einer größere Anzahl an Gitterstrukturelementen hervorgerufen. Dies führt im Verhältnis zu bekannten Laserdioden üblicherweise zu einer verbesserten Seitenmodenunterdrückung. Darüber hinaus können aufgrund der Erfindung aber auch Monomodestabilität, eine höhere Ausgangsleistung, ein niedrigerer Schwellenstrom, eine verbesserte Lebensdauer, sowie weitere verbesserte Bauteileigenschaften erreicht werden. Selbst wenn bei den genannten Bauteileigenschaften keine Verbesserung eintritt, so sind die genannten Bauteileigenschaften in Relation zu konventionellen Halbleiterlasern zumindest vergleichbar, sind also zumindest nicht wesentlich schlechter. Als Gitterstrukturen können beliebige Gitterformen, insbesondere auf bekannten Liniengittern aufbauende Formen gewählt werden. In letzterem Fall handelt es sich bei den Gitterstrukturelementen um die Gitterlinien.

Die Kopplungskonstante K zwischen Lichtwelle und Gitterstruktur beträgt K ≤ 30 cm⁻¹, vorzugsweise K ≤ 10 cm⁻¹. Die Kopplungskonstante ist dann in der Regel um etwa eine Größenordnung niedriger, als bei den bisher üblichen Halbleiterlasern. In jedem Fall kann die Kopplungskonstante durch einen entsprechenden Aufbau des Halbleiterlasers so gewählt werden, dass sie auf die Erfordernisse der jeweiligen Anwendung angepasst ist.

Besonders vorteilhaft ist es, wenn der Wellenleiterbereich zumindest einen Verstärkungsbereich zur Verstärkung der Lichtwelle aufweist, der beabstandet von der Gitterstruktur ist und zumindest einen Wechselwirkungsbereich zur Wechselwirkung zwischen Lichtwelle und Gitterstruktur aufweist, der benachbart zu der Gitterstruktur ist. Durch eine solche Trennung von Verstärkungsbereich und Wechselwirkungsbereich können nochmals verbesserte Bauteileigenschaften erreicht werden. Der beschriebene Halbleiterlaser unterscheidet sich somit von einem fachsprachlich Distributed-Feedback-Laser (DFB-Laser) genannten Laser, bei denen der Wechselwirkungsbereich und der Verstärkungsbereich des Halbleiterlasers zusammenfällt und der beispielsweise in "Lateral coupling - a material independent way to complex coupled DFB lasers" von M. Kamp et al., erschienen in ELSEVIER SCIENCE PUBLISHERS B.V. AMSTERDAM, NL, Bd, 17. Nr. 1-2, Juni 2001, Seiten 19-25 oder in PATENT ABSTRACTS OF JAPAN, Vol. 010, No. 170 (E-412), (1986-06-17) & JP 61 023383 A (MITSUBISHI DENKI KK), (1986-01-31) beschrieben wird. Vielmehr weist er Ähnlichkeiten mit sog. Distributed-Bragg-Reflector-Lasern (DBR-Laser) auf. Durch die Trennung von Verstärkungsbereich und Wechselwirkungsbereich ist eine jeweils getrennte Optimierung von Gitterstruktur bzw. Verstärkungsbereich deutlich erleichtert, da auf die Verhältnisse in den anderen Bereichen des Halbleiterlasers nur wenig Rücksicht genommen werden muss. Somit können durch eine Optimierung des Verstärkungsbereichs insbesondere geringere Verluste, geringere Schwellenstromdichten und eine höhere Ausgangseffizienz durch eine optimierte Strominjektion erreicht werden. Andererseits kann durch eine Optimierung der Gitterstruktureigenschaften insbesondere eine einfachere und bessere Kontrolle des Laseremissionsspektrums erzielt werden, ohne dass beispielsweise auf die Strominjektionseigenschaften bzw. die Materialverstärkungseigenschaften besonders geachtet werden muss. Auch die Dimensionierung der jeweiligen Bereiche kann im wesentlichen ohne Rücksichtnahme auf den jeweils anderen Bereich gewählt werden. So kann beispielsweise der Wechselwirkungsbereich, insbesondere auch im Verhältnis zum Verstärkungsbereich, besonders groß gewählt werden, um, in Kombination mit einem entsprechend niedrigen Kopplungskoeffizienten, besonders viele Gitterlinien mit der Lichtwelle Wechselwirken zu lassen, um so eine besonders gute Wellenlängenselektion und in der Folge eine besonders hohe Seitenmodenunterdrückung zu realisieren.

Obwohl die Gitterstruktur beliebig ausgebildet sein kann, beispielsweise als sog. indexgekoppeltes Gitter (index coupled grating) bzw. als verstärkungsgekoppeltes Gitter (gain coupled grating) hat es sich als besonders vorteilhaft erwiesen, wenn die Gitterstruktur als komplex gekoppelte Gitterstruktur ausgebildet ist. Die Gitterstruktur ist dann bezüglich des Realteils, als auch des Imaginärteils des Brechungsindex moduliert. Die Gitterstruktur moduliert folglich periodisch die Verluste und die Brechungsstärke für das sich durch den Laser hindurch ausbreitende Licht. Laserdioden mit derartigen Gitterstrukturen weisen eine hohe Rückstrahlungsunempfindlichkeit auf, die einen Einsatz ohne optischen Isolator, beispielsweise in Anwendungen zur Glasfaserübertragung, möglich macht.

Eine besonders elegante Methode, um den Verstärkungsbereich geometrisch zu definieren, besteht darin, dass im Verstärkungsbereich ein elektrischer Kontakt zwischen Wellenleiterbereich und einer Kontaktmetallisierung ausgebildet ist. In diesem Fall kann sich die Laserschicht über die gesamte Grundfläche des Halbleiterlasers erstrecken, wobei dennoch ein Verstärkungsbereich und ein Wechselwirkungsbereich ohne Verstärkungswirkung realisierbar ist. Der besondere Vorteil einer sich über die gesamte Grundfläche des Halbleiterlasers erstreckenden Laserschicht liegt in dem besonders einfachen Aufbau. So kann das Substratmaterial flächig mit der Laserschicht, beispielsweise durch ein unstrukturiertes Epitaxieverfahren, beschichtet werden, was besonders kostengünstig ist. Ein Pumpen des Halbleiterlasers findet jedoch nur in dem Abschnitt des Wellenleiterbereichs statt, der in elektrischem Kontakt mit der Kontaktmetallisierung steht, wenn die Kontaktmetallisierung mit einer elektrischen Spannung beaufschlagt wird. Nur in diesem Abschnitt kommt es zu einer Pumpwirkung und somit zu einer Verstärkung der im Halbleiterlaser befindlichen Lichtwelle. Je nach Erfordernis ist es möglich, dass der Bereich des elektrischen Kontakts zwischen Kontaktmetallisierung und Wellenleiterbereich einen gewissen Abstand zu sonstigen Bereichen des Halbleiterlasers, wie insbesondere den WechselWirkungsbereichen, aufweist, oder aber auch zumindest teilweise mit diesen überlappt.

Ein nochmals vereinfachter Aufbau ergibt sich, wenn außerhalb des Verstärkungsbereichs zwischen Kontaktmetallisierung und unmittelbar dazu benachbarten Bereichen des Halbleiterlasers eine elektrische Isolationsschicht ausgebildet ist. In diesem Fall muss die Kontaktmetallisierung nicht entsprechend der Strukturierung des Wellenleiterbereichs im Bereich des Verstärkungsbereichs erfolgen. Insbesondere ist es möglich, eine deutlich größere Kontaktmetallisierung aufzubringen, die eine vereinfachte Kontaktierungsmöglichkeit mit beispielsweise einem Drahtleiter ermöglicht. Auch an einer Stromzuführung von der Seite des Halbleiterlasers aus, welche beispielsweise durch eine Art Klemme realisiert werden könnte, ist zu denken.

Wenn Verstärkungsbereiche und Wechselwirkungsbereiche jeweils benachbart zueinander liegen, können durch das Vermeiden von "funktionsfreien" Bereichen (weder Wechselwirkung noch Verstärkung) die Bauteileigenschaften des Halbleiterlasers nochmals verbessert werden. So kann beispielsweise die Größe des Halbleiterlasers nochmals verringert werden. Auch kommt es zu weniger Dämpfungseffekten durch von der Lichtwelle zu durchlaufende "funktionsfreie" Bereiche, so dass auch die sonstigen Bauteileigenschaften verbessert werden können. Unter "benachbart zueinander" ist jedoch gegebenenfalls auch ein geringer Abstand zwischen beiden Bereichen zu verstehen, der insbesondere zur Verhinderung von gegenseitigen Beeinflussungen, eines Proximity-Effekts oder der vereinfachten Herstellung des Halbleiterlasers dienen kann.

Vorteilhaft ist es auch, wenn die Gitterstruktur in einer parallel zur Laserschicht verlaufenden Ebene angeordnet ist. In diesem Fall verläuft die Gitterstruktur in Richtung der Lichtwellen, die im Verstärkungsbereich verstärkt werden. Darüber hinaus ist eine Ausbildung bzw. eine Prozessierung der Gitterstruktur durch übliche Materialbearbeitungsverfahren, wie Epitaxieverfahren, Lithografie-Verfahren oder Ätzverfahren, besonders einfach möglich.

Möglich ist es, dass ein Wechselwirkungsbereich nur in einem Endbereich des Halbleitersubstrats vorgesehen ist. In diesem Fall kann eine besonders einfache Auskopplung der Lichtwelle aus dem Halbleiterlaser realisiert werden.

Möglich ist es jedoch auch, dass ein Wechselwirkungsbereich in beiden Endbereichen des Halbleitersubstrats vorgesehen ist. Bei dieser Ausbil dungsform kann das Bauteil beispielsweise eine nochmals besonders erhöhte Seitenmodenunterdrückung aufweisen.

Vorteilhaft kann es auch sein, dass in zumindest einem Wechselwirkungsbereich zumindest eine Wechselwirkungsbereichskontaktmetallisierung aufgebracht ist, welche einen elektrischen Kontakt mit dem Wellenleiterbereich aufweist. Durch diese Ausbildung ist es möglich, unabhängig vom Verstärkungsbereich auch im Wechselwirkungsbereich eine Verstärkung der Lichtwelle zu erreichen. Damit lassen sich beispielsweise eine besonders hohe Ausgangsleistung oder eine Verstimmung der emittierten Laserstrahlung erzielen. Zu unterschiedlichen Wechselwirkungsbereichskontaktmetallisierungen können dabei selbstverständlich getrennt voneinander ausgebildet sein. Auch können in einem WechselWirkungsbereich mehrere voneinander unabhängige Wechselwirkungsbereichsmetallisierungen aufgebracht sein.

Wenn zur Ausbildung der Gitterstruktur ein Metall, beispielsweise Chrom, verwendet wird, werden die vorstehend beschriebenen vorteilhaften Effekte besonders umfassend realisierbar. Unabhängig von dem zur Ausbildung der Gitterstruktur gewählten Material kann die Gitterstruktur auch durch einen Materialabtrag, also nicht nur durch einen Materialauftrag, erzeugt werden.

Möglich ist es auch, dass die Gitterstruktur aus dem Substratmaterial selbst gebildet ist. Insbesondere die Ausbildung eines selbstjustierenden Gitters ist damit möglich.

Als besonders vorteilhaft hat es sich ferner erwiesen, wenn das Substrat im wesentlichen aus Indiumphosphid (InP) ausgebildet ist. Dieses Material eignet sich besonders gut für die Ausbildung eines erfindungsgemäßen Halbleiterlasers.

Zur Erreichung einer niedrigeren Kopplung zwischen Lichtwelle und Gitterstruktur ist es vorteilhaft, wenn die Gitterstruktur in zumindest einem Wechselwirkungsbereich zwei Strukturbereiche aufweist, die beidseitig des Wellenleiterbereichs angeordnet sind. Je nach der Größe der jeweiligen Elemente kann auf einfache Weise eine unterschiedlich starke Kopplung zwischen Lichtwelle und Gitterstruktur erzielt werden. Wenn beispielsweise der Wellenleiterbereich stegartig ausgebildet ist und breiter gewählt wird, so erfolgt ein geringerer Überlapp zwischen Lichtwelle und Gitterstruktur, so dass eine geringere Wechselwirkung auftritt. Durch die beidseitige Anordnung von Strukturbereichen wird darüber hinaus eine Symmetrie erreicht, die sich besonders vorteilhaft auf die Bauteileigenschaften auswirkt.

Ebenso ist es denkbar, dass die Gitterstruktur in zumindest einem Wechselwirkungsbereich einen Strukturbereich aufweist, der längs einer Seite des Wellenleiterbereichs angeordnet ist. Da somit nur an einer Seite des Wellenleiterbereichs eine Kopplung zwischen Lichtwelle und Gitterstruktur auftritt, wird somit die resultierende Kopplung im wesentlichen halbiert.

In jedem Fall erweist es sich als vorteilhaft, wenn die Strukturbereiche der Gitterstruktur angrenzend an seitliche Flanken des Wellenleiterbereichs angeordnet sind. Hierdurch wird eine möglichst fein abstufbare Kopplungscharakteristik zwischen Laserstrahlung und Gitterstruktur erleichtert. So ist durch Wahl einer entsprechenden Querschnittsgeometrie der jeweiligen Gitterstrukturen die Kopplungscharakteristik einstellbar. Unter "angrenzend" ist dabei auch ein geringer Abstand zwischen Gitterstruktur und Wellenleiterbereich zu verstehen. Auch über die Größe eines solchen Abstands lässt sich die Kopplungscharakteristik beeinflussen.

Bezüglich einer möglichst einfachen Herstellung und einer Maximierung der im Rahmen des Bearbeitungsverfahrens erreichbaren Genauigkeit sind vorzugsweise die Flanken des Wellenleiterbereichs im wesentlichen rechtwinklig zur Erstreckungsebene der Gitterstruktur angeordnet.

Das erfindungsgemäße Verfahren weist die Merkmale des Anspruchs 18 auf. Gemäß dem vorgeschlagenen Verfahren erfolgt, basierend auf einem Halbleitersubstrat, die Herstellung einer vollständigen Halbleiterstruktur in einem Epitaxieverfahren mit anschließender Herstellung eines Wellenleiterbereichs durch Beaufschlagung der Halbleiterlaserstruktur mit einem Materialabtragsverfahren zur Ausbildung von seitlich des Wellenleiterbereichs angeordneten Trägerflächen, sowie anschließender Aufbringung der Gitterstruktur auf die Trägerflächen im Bereich der Wechselwirkungsbereiche. Es kann dabei jedem Halbleiterlaser auch nur eine einzelne Trägerschicht zugeordnet sein.

Wenn nach dem Aufbringen der Gitterstruktur im Bereich der Trägerflächen, insbesondere im Bereich der Wechselwirkungsabschnitte auf den Trägerflächen, eine Isolierschicht ausgebildet wird, so kann ein Schutz der Gitterstrukturen erzielt werden und eine Beaufschlagung im Bereich der Gitterstrukturen mit einem elektrischen Strom, der zu einer Verstärkungswirkung im Wechselwirkungsbereich führen könnte, wirksam verhindert werden.

Es ist möglich, dass zur Aufbringung einer Gitterstruktur aus Metall, ein Lithografie-Verfahren mit nachfolgender Metallisierung der lithografischen Struktur eingesetzt wird. Dieses Verfahren der Gitterherstellung ist nahezu materialunabhängig und kann auf verschiedenen Halbleitersystemen eingesetzt werden. Auch das Gitter kann mit unterschiedlichsten Materialien realisiert werden, sofern ein genügend hoher Brechungsindexkontrast bzw. Absorptionskontrast vorhanden ist, um die Rückkopplungseigenschaften zu gewährleisten. Das Lithografie-Verfahren kann mittels eines Fotolacks oder eines Elektronenstrahllacks mittels Maske oder fokussierter Strahlung definiert werden und mit einem Transferschritt (z.B. über einen Lift-Off-Schritt oder zusätzlichen Ätzschritt) auf eine Metallschicht übertragen werden.

Es ist aber auch möglich, dass zur Aufbringung der Gitterstruktur ein Ionenimplantationsprozess eingesetzt wird. Dieser kann entweder maskenlos über einen fokussierten Ionenstrahl oder mit Hilfe einer Maske über einen homogenen Ionenstrahl erzeugt werden. Im System Indiumphosphid (InP) hat sich ein Galliumionenstrahl (Ga⁺) bewährt. In jedem Fall werden durch den Ionenimplatationsprozess Kristallgitterdefekte im Substratmaterial erzeugt.

Es ist vorteilhaft, wenn durch den Ionenimplantationsprozess entstandene Kristallgitterdefekte, insbesondere tief im Substratmaterial befindliche Kristallgitterdefekte, mittels eines Ausheilschritts zumindest teilweise ausgeheilt werden. Dieser Ausheilschritt kann zu einer selektiven Durchmischung der aktiven Zone führen, so dass die Absorption im Bereich der Bandlücke im Bereich der implantierten Ionen reduziert werden kann, so dass eine modulierte, verstärkungsgekoppelte Gitterstruktur entsteht. Da durch sog. "channeling" Ionen gegebenenfalls sehr tief in das Kristallgitter eindringen können, kann sich der Ausheilschritt auch anderweitig positiv auf die Bauteileigenschaften auswirken.

Ferner können durch den Ionenimplantationsprozess entstandene Kristallgitterdefekte, insbesondere stärker gestörte, oberflächennahe Kristallgitterdefekte, durch ein Materialabtragsverfahren, insbesondere durch einen Ätzvorgang abgetragen werden. Die oberflächennahen Kristallgitterdefekte sind üblicherweise besonders stark ausgeprägt, so dass diese durch einen selektiven Ätzprozess entfernt werden können.

Insbesondere durch eine Kombination von Ausheilprozess und anschließendem Materialabtragsverfahren kann auf besonders einfache Weise ein komplex gekoppeltes Gitter erzeugt werden, wobei beide Teilgitter (Durchmischungsgitter und geätztes Gitter) selbst justierend sind. Die Kombination beider Prozesse hat sich insbesondere bei Indiumphosphid (InP) besonders bewährt, kann jedoch prinzipiell auch in anderen Materialsystemen vorteilhaft eingesetzt werden.

Eine besonders in ökonomischer Hinsicht vorteilhafte Variante des Herstellungsverfahrens wird möglich, wenn zur Herstellung einer Vielzahl von Halbleiterlasern mit unterschiedlichen Eigenschaften zunächst die Herstellung eines Halbleiterwafers unter Aufbringung einer Epitaxiestruktur auf einem Halbleitersubstrat erfolgt, und anschließend die Erzeugung der den einzelnen Laserdioden zugeordneten Wellenleiterbereiche im Waferverbund folgt, also durch Erzeugung einer auf der Oberfläche des Halbleiterlaserwafers angeordneten stegförmigen Wellenleiterstruktur mit zueinander parallelen Wellenleiterbereichen und zwischenliegend ausgebildeten Trägerflächen. Erst daran anschließend erfolgt die Zerteilung des Halbleiterwafers in vereinzelte Halbleiterlaserchipeinheiten, wobei dann die exakte Definition der den einzelnen Laserdioden zugeordneten Eigenschaften über die Aufbringung bzw. Implantation einer Gitterstruktur mit entsprechenden Strukturparametern auf der Oberfläche einer ausgewählten Anzahl von Laserdioden erfolgt.

Hierdurch ist es also möglich, die im Waferverbund hergestellten, bereits mit dem Wellenleiterbereich versehenen Laserdioden als in ihren elektrischen und optischen Eigenschaften definierte Basislaserdioden oder "Rohlaserdioden" zu nutzen, um dann anschließend aus diesem Reservoir identisch ausgebildete Basislaserdioden jeweils die benötigte Anzahl auszuwählen und durch Ausbildung von definierten Gitterstrukturen weitestgehend ohne Ausschuss die gewünschte Anzahl von in ihren optischen und elektrischen Eigenschaften exakt definierten monomodigen Halbleiterlaserdioden herzustellen.

Nachfolgend wird der Aufbau einer möglichen Ausführungsform einer erfindungsgemäßen Halbleiterlaserdiode und ein mögliches Verfahren zu deren Herstellung anhand der Zeichnung näher erläutert. Es zeigen:
- **Fig. 1a** bis **e**: verschiedene Stadien bei der Herstellung einer möglichen Ausführungsform einer DBR-Laserdiode mit schwacher Kopplung zwischen Lichtwelle und Gitterstruktur;
- **Fig. 2**: eine zweite mögliche Ausführungsform einer DBR-Laserdiode mit schwacher Kopplung zwischen Lichtwelle und Gitterstruktur in schematischer Ansicht;
- **Fig. 3 a** und **b**: die Intensitätsverteilung der Lichtwelle im Wechselwirkungsbereich einer Laserdiode bei unterschiedlich starker Kopplung zwischen Lichtwelle und Gitterstruktur.

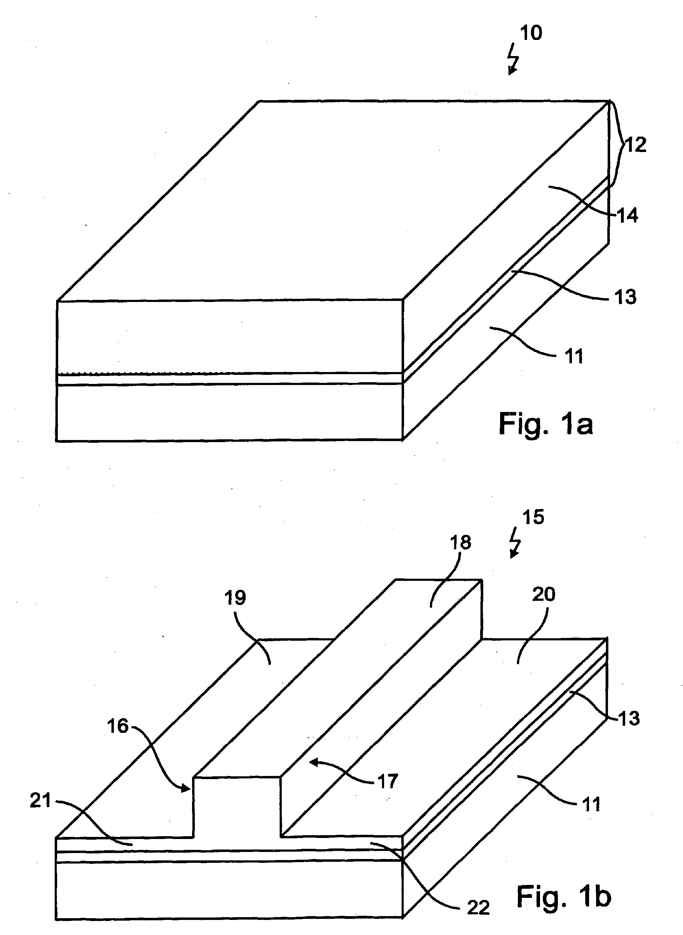

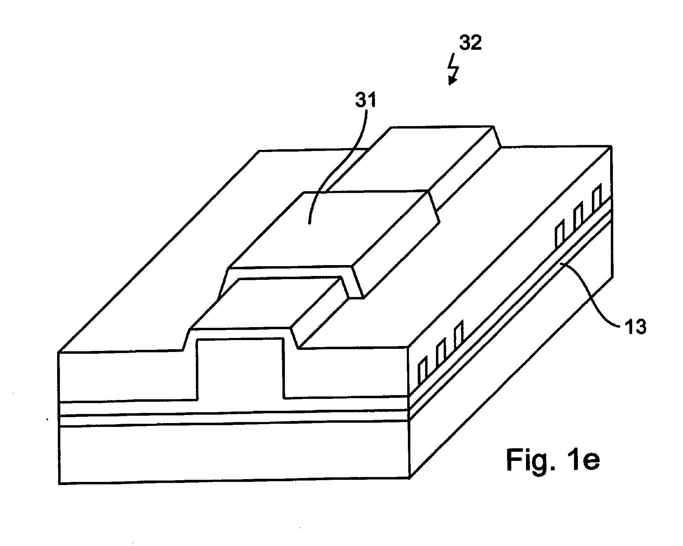

**Fig. 1a** zeigt eine Basislaserdiode 10, welche als Ausgangsbasis zur Herstellung eines Halbleiterlasers **(****Fig. 1e****)** dient, in vereinfachter Darstellung in perspektivischer Ansicht. Die Basislaserdiode 10 besteht im vorliegenden Ausführungsbeispiel aus einem Substrat 11, das vorliegend aus Indiumphosphid (InP) besteht. Es sind jedoch auch andere Halbleitermaterialien denkbar. Auf dem Substrat 11 ist durch an sich bekannte Verfahren eine Epitaxiestruktur 12 aufgebracht worden. Die Epitaxiestruktur 12 besteht im wesentlichen aus einer Laserschicht 13, welche optisch aktiv ist, sowie einer Decklage 14, welche im vorliegenden Beispiel aus dem gleichen Material wie das Substrat 11 besteht, also aus Indiumphosphid.

Ausgehend von der Basislaserdiode 10 wird zunächst die in **Fig. 1b** dargestellte Übergangsform einer Wellenleiterdiode 15 hergestellt. Dazu wird ein Teil der in **Fig. 1a** gezeigten Decklage 14 bereichsweise einem Materialabtragsverfahren unterzogen. Das Materialabtragsverfahren wirkt selektiv im Bereich der Seitenflächen 19 und 20. In der Mitte der Wellenleiterdiode 15 verbleibt ein Wellenleiterbereich, welcher im vorliegenden Ausführungsbeispiel als Wellenleitersteg 18 geformt ist. Die seitlichen Flanken 16 und 17 grenzen mit einem im wesentlichen rechten Winkel an die jeweiligen Seitenflächen 19 und 20 der Wellenlei terdiode 15 an. Wie aus der **Fig. 1b** deutlich zu erkennen ist, ist das Materialabtragsverfahren so gesteuert, dass die obere Decklage 14 **(****Fig. 1a****)** zwar verdünnt wird, jedoch nicht restlos abgetragen wird. Mit anderen Worten bestehen der Wellenleitersteg 18, sowie die zwischen den Seitenflächen 19 und 20 und der Laserschicht 13 befindlichen Laser schichtdecken 21 und 22 aus dem gleichen Material, im vorliegenden Ausführungsbeispiel also aus Indiumphosphid.

Das Materialabtragsverfahren kann beliebig gewählt werden. Beispielsweise können an sich bekannte Verfahren, wie beispielsweise Trockenätzverfahren, Nassätzverfahren usw., verwendet werden.

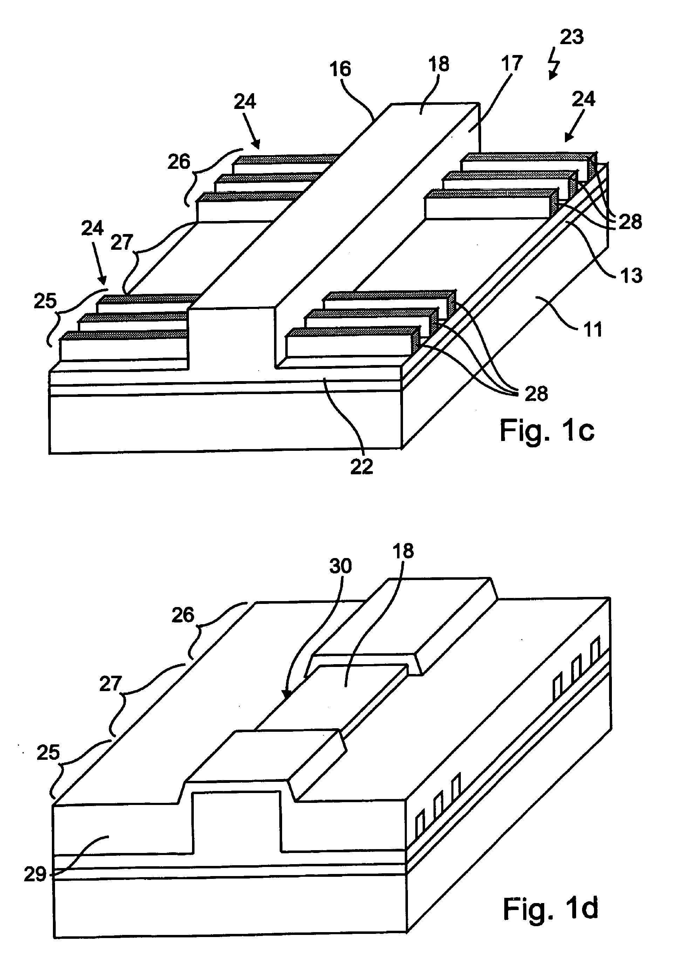

Durch Aufbringung einer Gitterstruktur auf die Seitenflächen 19 und 20 entsteht als weitere Übergangsform eine DBR-Rohlaserdiode 23 (DBR steht für Distributed Bragg Reflector). Wie in der **Fig. 1c** zu erkennen ist, werden auf beiden Seiten des Wellenleiterstegs 18 in einem ersten Wechselwirkungsbereich 25, sowie einem zweiten Wechselwirkungsbe reich 26 Gitterstegstrukturen 24 aufgebracht. Die Gitterstegstrukturen 24 bestehen im vorliegenden Beispiel jeweils aus drei Gitterstegen 28. Die Gitterstege 28 sind in den Gitterstegstrukturen 24 jeweils äquidistant angeordnet und so ausgerichtet, dass sie auf den beiden Seiten des Wellenleiterstegs 18 jeweils zueinander fluchtend ausgerichtet sind. Die beiden Wechselwirkungsbereiche 25 und 26 befinden sich an den beiden Enden der DBR-Rohlaserdiode 23, wobei die Längsrichtung durch den Wellenleitersteg 18 definiert ist. Zwischen den beiden Wechselwirkungsbereichen 25 und 26 erstreckt sich ein Verstärkungsbereich 27, in dem in der fertigen DBR-Laserdiode 32 die Laserlichtverstärkung erfolgt und in dem keine Gitterstrukturen ausgebildet sind.

Vorliegend sind die Gitterstrukturen 24 als Metallgitterstrukturen ausgeführt. Dies kann beispielsweise durch Abscheidung eines Metalls, beispielsweise Chrom, auf die beiden Seitenflächen 19 und 20 der in **Fig. 1b** gezeigten Wellenleiterdiode 15 erfolgen. Anschließend wird in der so aufgebrachten Metallschicht durch einen Fotolack bzw. einen Elektronenlack und anschließender Belichtung mit Licht bzw. beschleunigten Elektronen die Gitterstruktur definiert. Anschließend werden durch ein Materialabtragsverfahren, beispielsweise durch ein Ätzverfahren, die zu entfernenden Schichten abgetragen. Möglich wäre selbstverständlich auch die Aufbringung einer Ätzstoppschicht mit einem anschließenden Ätzschritt oder beliebige andere Verfahren.

Eine weitere, hier nicht dargestellte Möglichkeit besteht darin, dass in einem maskenlosen Verfahren ein gebündelter Ionenstrahl die Gitterstruktur direkt in den Laserschichtdecken 21 und 22 **(****Fig. 1b****)** definiert. Es kann selbstverständlich auch ein unfokussierter Ionenstrahl zusammen mit einer Maske verwendet werden. In jedem Fall werden in den mit Ionen beaufschlagten Bereichen der Laserschichtdecken 21 und 22 Kristallgitterdefekte im jeweiligen Material erzeugt. In einem anschließenden Ausheilschritt durch Temperaturerhöhung führt dies zu einer selektiven Durchmischung der aktiven Zone. Zusätzlich können auch noch die stärker gestörten oberflächennahen Bereiche durch einen selektiven Ätzprozess entfernt werden. Dadurch entsteht ein komplex gekoppeltes Gitter, wobei die beiden Teilgitter (also Durchmischungsgitter und geätztes Gitter) selbst justierend sind.

Beim vorliegend beschriebenen Indiumphosphidsystem haben sich zur Implantation Ga⁺-Ionen mit 100 keV bewährt. Als Ausheilschritt wurde eine Temperaturerhöhung auf 750° C für eine Zeitdauer von 60 s verwendet. Der Ätzvorgang kann durch ein 10-minütiges Bad in 10 %-iger HF-Lösung bei 80° C erfolgen.

Unabhängig vom jeweiligen Materialauftrags- bzw. Materialabtragsverfahren erhält man die in **Fig. 1c** gezeigte bzw. eine dazu ähnlich gestaltete Struktur einer DBR-Rohlaserdiode 23 als Übergangsform.

In einem weiteren Verfahrensschritt wird nunmehr die Oberfläche der DBR-Rohlaserdiode 23 mit einer Isolierschicht 29 abgedeckt (siehe **Fig. 1d****).** Im Bereich der beiden Wechselwirkungsbereiche 25 und 26 überdeckt die Isolierschicht 29 die entsprechenden Bereiche der Seitenflächen 19 und 20 **(****Fig. 1b**), die darauf ausgebildeten Gitterstegstrukturen 24, sowie den Wellenleitersteg 18 **(****Fig. 1b**). Dagegen bedeckt die Isolierschicht 29 im Verstärkungsbereich 27 nur die entsprechenden Bereiche der Seitenflächen 19 und 20. Der Wellenleitersteg 18 dagegen ist in diesem Bereich von der Isolierschicht 29 nicht bedeckt, und daher durch die Aussparung 30 hindurch von außen her zugänglich. In einem letzten Schritt wird im Bereich dieser Aussparung 30 der Isolierschicht 29 eine Kontaktmetallisierung 31 ausgebildet, so dass die nunmehr fertige DBR-Laserdiode 32 (Fig. 1e) mit einem hier nicht dargestellten Anschlussleiter kontaktiert werden kann. In der gewählten, vereinfachten Ansicht sind weitere Anschlusskontakte, insbesondere für die Laserschicht 13, aus Übersichtsgründen weggelassen. Diese sind in bekannter Weise ausführbar.

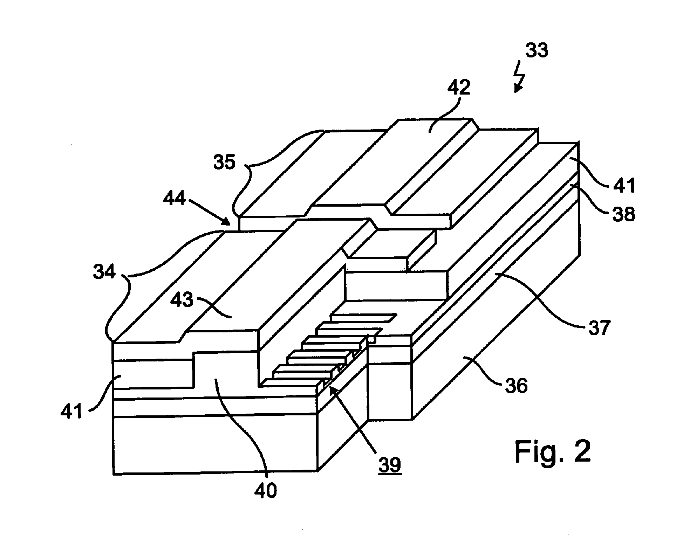

In **Fig. 2** ist eine zweite Ausführungsmöglichkeit einer schwach gekoppelten Laserdiode dargestellt. Um den Aufbau der Laserdiode zu illustrieren, sind in der Zeichnung Ausnehmungen dargestellt, die im fertigen Bauteil selbstverständlich nicht vorhanden sind. Die Laserdiode ist als asymmetrische DBR-Laserdiode 33 ausgeführt. Sie weist lediglich auf einer Seite der Diode einen Wechselwirkungsbereich 34 auf. Das andere Ende der asymmetrischen Laserdiode 33 dient als Verstärkungsbereich 35. Der Aufbau erfolgt auf einem Substrat 36. Auf diesem ist analog zur Laserdiode 32 in **Fig.** 1e eine Laserschicht 37 ausgebildet, welche sich über die gesamte Fläche der asymmetrischen DBR-Laserdiode 33 erstreckt. Auf der Laserdiode 37 ist eine geätzte Halbleiteroberfläche 38 angeordnet, welche vorliegend aus dem gleichen Material wie das Substrat 36 besteht. Die Gitterstrukturen 39 im Wechselwirkungsbereich 34 sind vorliegend als komplex gekoppeltes Gitter ausgebildet und wurden durch den bereits beschriebenen Ionenimplantationsprozess mit anschließendem Ausheilschritt und Materialabtragsschritt hergestellt. Eine entsprechende Gitterstruktur 39 findet sich auch auf der anderen Seite des Wellenleiterstegs, ist jedoch aufgrund der gewählten Perspektive nicht erkennbar. Auf den beiden Seitenflächenbereichen seitlich des Wellenleiterstegs 40 ist über die gesamte Länge der asymmetrischen DBR-Laserdiode 33 eine Isolatorschicht 41 aufgebracht, welche lediglich den Wellenleitersteg 40 frei lässt. Auf der Oberfläche der asymmetrisehen DBR-Laserdiode 33 sind zwei Kontaktmetallisierungen 42, 43 ausgebildet, welche durch eine hier schlitzförmige Aussparung 44 voneinander getrennt sind. Durch eine Beaufschlagung der ersten Kontaktmetallisierung 42 durch einen elektrischen Strom wird der Verstärkungsbereich 35 gepumpt, so dass eine Laserlichtverstärkung auftritt. Der Wechselwirkungsbereich 34 nimmt mittels seiner Gitterstrukturen 39 in Abhängigkeit vom Abstand der jeweiligen Gitterlinien untereinander eine Wellenlängenselektion des Lichts vor. Die beiden Kontaktmetallisierungen 42, 43 sind mit den jeweiligen Bereichen des Wellenleiterstegs 40 elektrisch verbunden.

Zusätzlich zu, aber auch unabhängig von, der normalen Betriebsweise, bei der die erste Kontaktmetallisierung 42 mit einer elektrischen Spannung versorgt wird, kann bei der dargestellten asymmetrischen DBR-Laserdiode 33 auch die zweite Kontaktmetallisierung 43 mit einer elektrischen Spannung versorgt werden. Dadurch wird unabhängig von einer Verstärkung im Verstärkungsbereich 35 auch im Wechselwirkungsbereich 34 eine Verstärkung der Lichtwelle bewirkt. In der Regel geht dies mit einer etwas schlechteren Seitenmodenunterdrückung einher. Auf der anderen Seite kann jedoch eine höhere Lichtleistung erzeugt werden. Die asymmetrische DBR-Laserdiode 33 kann somit für unterschiedliche Aufgaben flexibel eingesetzt werden.

Im Falle eines Halbleiterlasers mit zwei Wechselwirkungsbereichen an den beiden Enden der Laserdiode können entsprechend beide Wechsel wirkungsbereiche durch jeweils eine, oder auch mehrere, im jeweiligen Wechselwirkungsbereich angeordnete, zusätzliche Kontaktmetallisierungen versehen werden, die jeweils voneinander unabhängig angesteuert werden können. Somit ergibt sich eine Vielzahl von Möglichkeiten bei der Ansteuerung der Laserdiode, und somit vielfältige Beeinflussungsmöglichkeiten der Emissionscharakteristik der Laserdiode.

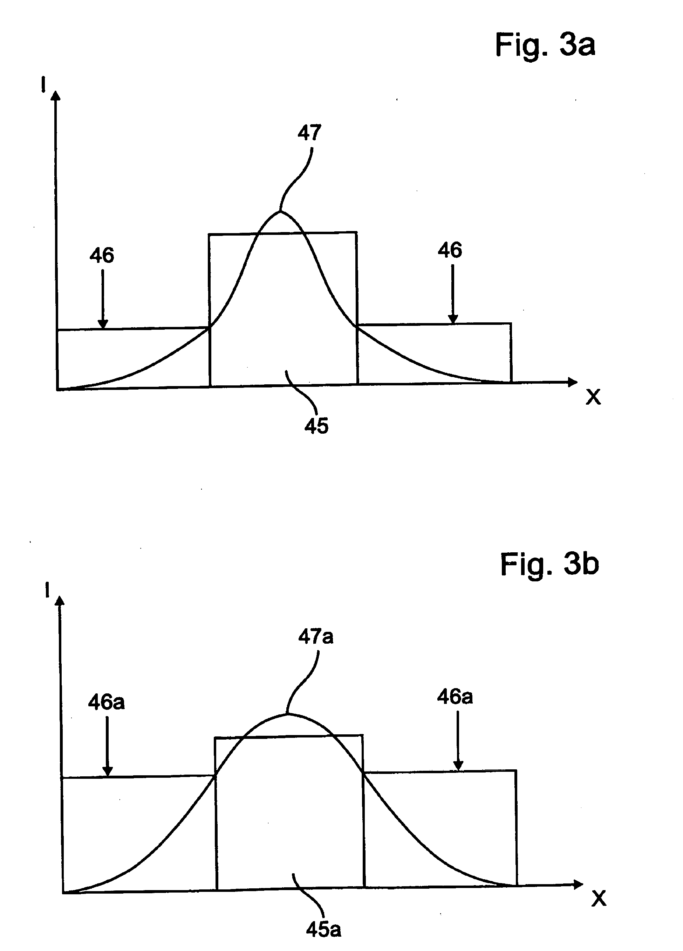

In **Fig. 3** ist beispielhaft eine Anpassung der Kopplung zwischen Licht welle 47, 47a und Gitterstruktur 46, 46a durch unterschiedliche Dimensionierung der Gitterstrukturen 46, 46a, sowie des Wellenleiterstegs 45, 45a dargestellt. In **Fig. 3a** befindet sich der größte Anteil der Lichtwel lenleistung 47 innerhalb des Wellenleiterstegs 45. Der Überlapp der Lichtwelle mit den Gitterstrukturen 46 ist dagegen nur gering, so dass zwischen Lichtwelle und Gitterstruktur 46 nur eine geringe Kopplung auftritt. Somit erfolgt die Wechselwirkung zwischen Lichtwelle und Gitterstruktur 46 über eine größere Anzahl von Gitterlinien hinweg, so dass die Frequenzselektion im Verhältnis zu bekannten Laserdioden unter Umständen deutlich verbessert wird. Dies setzt selbstverständlich eine ausreichend große Anzahl an Gitterlinien bei der Laserdiode voraus. Es ist auch denkbar, dass zwischen Wellenleitersteg 45 und Gitterstruktur 46 jeweils ein dünner Spalt ausgebildet wird, und auf diese Weise eine entsprechend geringe Kopplung zwischen Lichtwelle und Gitterstruktur 46 vorhanden ist. Es ist auch einsichtig, dass eine nur an einer Seite des Wellenleiterstegs 45 angeordnete Gitterstruktur 46 eine nochmals verringerte Kopplung zwischen Lichtwelle 47 und Gitterstruktur 46 bewirken würde.

Zum Vergleich ist in **Fig. 3b** eine starke Kopplung zwischen Lichtwelle 47a und Gitterstruktur 46a dargestellt. Hier tritt ein großer Überlapp zwischen Lichtwelle 47a und Gitterstruktur 46a auf, so dass eine entsprechend starke Kopplung zwischen Lichtwelle 47a und Gitterstrukturen 46a resultiert. Nur ergänzend wird daraufhingewiesen, dass die bei bekannten Lasern vorhandene starke Kopplung zwischen Lichtwelle und Gitterstruktur auch durch andere konstruktive Aufbauten realisiert wurde.

## Patentansprüche

1. Halbleiterlaser zur Erzeugung einer Lichtwelle, mit einem Halbleitersubstrat (11, 36), einer auf dem Halbleitersubstrat angeordneten Laserschicht (13,37), einem zumindest teilweise benachbart zur Laserschicht angeordneten Wellenleiterbereich (18, 40) und einer streifenförmig ausgebildeten Gitterstruktur (24, 39),
**dadurch gekennzeichnet,**
**dass** der Wellenleiterbereich (18, 40) zumindest einen Verstärkungsbereich (27, 35) zur Verstärkung der Lichtwelle aufweist, der beabstandet von der Gitterstruktur (24, 39) angeordnet ist und
zumindest einen Wechselwirkungsbereich (25, 26, 34) zur Wechselwirkung zwischen Lichtwelle und Gitterstruktur (24, 39) aufweist, der benachbart zu der Gitterstruktur ist.
und **dadurch gekennzeichnet,**
**dass** Laserschicht, Wellenleiterbereich und Gitterstruktur derart aufeinander angepasst sind, dass eine nur schwache Kopplung zwischen Lichtwelle und Gitterstruktur erfolgt mit einer Kopplungskonstante K zwischen Lichtwelle und Gitterstruktur von K≤30 cm⁻¹,
vorzugsweise K≤10 cm⁻¹.

2. Halbleiterlaser nach Anspruch 1,
**dadurch gekennzeichnet,**
**dass** eine indexgekoppelte Gitterstruktur in zumindest einem Wechselwirkungsbereich zwei Strukturbereiche (24, 39) aufweist, die beidseitig des Wellenleiterbereichs (18, 40) angeordnet sind.

3. Halbleiterlaser nach einem der vorangehenden Ansprüche,
**dadurch gekennzeichnet,**
**dass** die Gitterstruktur (24, 39) als komplex gekoppelte Gitterstruktur ausgebildet ist.

4. Halbleiterlaser nach einem der vorangehenden Ansprüche,
**dadurch gekennzeichnet,**
**dass** im Verstärkungsbereich (27, 35) ein elektrischer Kontakt zwischen Wellenleiterbereich (18, 40) und einer Kontaktmetallisierung (31, 42) ausgebildet ist.

5. Halbleiterlaser nach einem der vorangehenden Ansprüche,
**dadurch gekennzeichnet,**
**dass** außerhalb des Verstärkungsbereichs (27, 35) eine elektrische Isolationsschicht (29, 41) zwischen Kontaktmetallisierung (31, 42, 43) und unmittelbar dazu benachbartem Teil des Halbleiterlasers ausgebildet ist.

6. Halbleiterlaser nach einem der vorangehenden Ansprüche,
**dadurch gekennzeichnet, dass** Verstärkungsbereiche (27, 35) und Wechselwirkungsbereiche (24, 25, 34) jeweils benachbart zueinander liegen.

7. Halbleiterlaser nach einem der vorangehenden Ansprüche,
**dadurch gekennzeichnet,**
**dass** die Gitterstruktur (24, 39) in einer parallel zur Laserschicht (13, 37) verlaufenden Ebene angeordnet ist.

8. Halbleiterlaser nach einem der vorangehenden Ansprüche,
**dadurch gekennzeichnet,**
**dass** ein Wechselwirkungsbereich (34) nur in einem Endbereich des Halbleitersubstrats (36) vorgesehen ist.

9. Halbleiterlaser nach einem der Ansprüche 1 bis 7,
**dadurch gekennzeichnet,**
**dass** ein Wechselwirkungsbereich (24, 25) in beiden Endbereichen des Halbleitersubstrats (11) vorgesehen ist.

10. Halbleiterlaser nach einem der vorangehenden Ansprüche,
**dadurch gekennzeichnet,**
**dass** in zumindest einem Wechselwirkungsbereich (34) zumindest eine Wechselwirkungsbereichskontaktmetallisierung (43) aufgebracht ist, welche einen elektrischen Kontakt mit dem Wellenleiterbereich (40) aufweist.

11. Halbleiterlaser nach einem der vorangehenden Ansprüche,
**dadurch gekennzeichnet,**
**dass** die Gitterstruktur (24) aus Metall, insbesondere Chrom oder einer Chromlegierung, hergestellt ist.

12. Halbleiterlaser nach einem der vorangehenden Ansprüche,
**dadurch gekennzeichnet,**
**dass** die Gitterstruktur (39) aus dem Substratmaterial gebildet ist.

13. Halbleiterlaser nach einem der vorangehenden Ansprüche,
**dadurch gekennzeichnet,**
**dass** das Substrat (11, 36) im wesentlichen aus InP ausgebildet ist.

14. Halbleiterlaser nach einem der vorangehenden Ansprüche,
**dadurch gekennzeichnet,**
**dass** die Gitterstruktur in zumindest einem Wechselwirkungsbereich zwei Strukturbereiche (24, 39) aufweist, die beidseitig des Wellenleiterbereichs (18, 40) angeordnet sind.

15. Halbleiterlaser nach einem der vorangehenden Ansprüche,
**dadurch gekennzeichnet,**
**dass** die Gitterstruktur in zumindest einem Wechselwirkungsbereich einen Strukturbereich aufweist, der längs einer Seite des Wellenleiterbereichs angeordnet ist.

16. Halbleiterlaser nach einem der vorangehenden Ansprüche,
**dadurch gekennzeichnet,**
**dass** die Strukturbereiche (24, 39) der Gitterstruktur angrenzend an seitliche Flanken (16, 17) des Wellenleiterbereichs (18, 40) angeordnet sind.

17. Halbleiterlaser nach einem der vorangehenden Ansprüche,
**dadurch gekennzeichnet,**
**dass** die Flanken des Wellenleiterbereichs im wesentlichen rechtwinklig zur Erstreckungsebene der Gitterstruktur angeordnet sind.

18. Verfahren zur Herstellung eines Halbleiterlasers (32, 33) gemäß einem der Ansprüche 1 bis 17
**gekennzeichnet durch** die Verfahrensschritte:
- Herstellung einer vollständigen Halbleiterlaserstruktur in einem Epitaxieverfahren,
- Herstellung eines Wellenleiterbereichs (18, 40) **durch** Beaufschlagung der Halbleiterlaserstruktur mit einem Materialabtragsverfahren zur Ausbildung von seitlich des Wellenleiterbereichs (18) angeordneten Trägerflächen (19, 20),
- Aufbringung der Gitterstruktur (24) auf die Trägerflächen (19, 20) im Bereich der Wechselwirkungsbereiche (25, 26).
- Aufbringung einer Isolierschicht (29) im Bereich der Wechselwirkungsbereiche (25, 26).

19. Verfahren nach Anspruch 18,
**dadurch gekennzeichnet,**
**dass** zur Aufbringung einer Gitterstruktur aus Metall, ein Lithographieverfahren mit nachfolgender Metallisierung der lithographischen Struktur eingesetzt wird.

20. Verfahren nach Anspruch 18,
**dadurch gekennzeichnet,**
**dass** zur Aufbringung einer Gitterstruktur ein Ionenimplatationsprozess eingesetzt wird.

21. Verfahren nach Anspruch 20,
**dadurch gekennzeichnet,**
**dass** durch den lonenimplatationsprozess entstandene Kristallgitterdeekte, insbesondere tief im Substratmaterial befindliche Kristallgitterdefekte, mittels eines Ausheilschritts zumindest teilweise ausgeheilt werden.

22. Verfahren nach Anspruch 20 oder 21,
**dadurch gekennzeichnet,**
**dass** durch den lonenimplatationsprozess entstandene Kristallgitterdefekte, insbesondere oberflächennahe Kristallgitterdefekte, durch ein Materialabtragsverfahren, insbesondere durch einen Ätzvorgang, abgetragen werden.

23. Verfahren nach einem der Ansprüche 18 bis 22,
**dadurch gekennzeichnet,**
**dass** eine Vielzahl von Halbleiterlasern in einem Waferverbund hergestellt wird mit den Verfahrensschritten:
- Herstellung eines Halbleiterlaserwafers durch Aufbringung einer Epitaxiestruktur auf ein Halbleitersubstrat,
- Erzeugung einer auf der Oberfläche des Halbleiterlaserwafers angeordneten stegförmigen Wellenleiterstruktur mit zueinander parallelen Wellenleiterbereichen,
- Zerteilung des Halbleiterlaserwafers in einzelne Halbleiterlaserchipeinheiten,
- Erzeugung einer oder mehrerer Gitterstrukturen auf den Halbleiterlaserchipeinheiten.

## Claims

1. A semiconductor laser for generating a light wave, having a semiconductor substrate (11, 36), a laser layer (13, 37) arranged on the semiconductor substrate, a waveguide region (18, 40) arranged at least partially adjacent to the laser layer and a strip-shaped lattice structure (24, 39), **characterized in that**
the waveguide region (18, 40) has at least one gain region (27, 35) to amplify the light wave, which gain region is spaced apart from the lattice structure (24, 39) and has at least one interaction region (25, 26; 34) for the interaction between the light wave and the lattice structure (24, 39), which is adjacent to the lattice structure,
and **characterized in that**
the laser layer, the waveguide region and the lattice structure are adapted to one another in such a manner that there is only a weak coupling between the light wave and the lattice structure with a coupling constant K between the light wave and the lattice structure of K ≤ 30 cm⁻¹, preferably K ≤ 10 cm⁻¹.

2. The semiconductor laser according to claim 1, **characterized in that**
an index-coupled lattice structure has two structural regions (24, 39) in at least one interaction region, which structural regions are arranged on both sides of the waveguide region (18, 40).

3. The semiconductor laser according to one of the preceding claims,
**characterized in that**
the lattice structure (24, 39) is designed as a complexly coupled lattice structure.

4. The semiconductor laser according to one of the preceding claims,
**characterized in that**
an electrical contact is formed between the waveguide region (18, 40) and a contact metallization (31, 42) in the gain region (27, 35).

5. The semiconductor laser according to one of the preceding claims,
**characterized in that**
an electrical insulating layer (29, 41) is formed outside the gain region (27, 35) between the contact metallization (31, 42, 43) and part of the semiconductor laser directly adjacent thereto.

6. The semiconductor laser according to one of the preceding claims,
**characterized in that**
gain regions (27, 35) and interaction regions (24, 25, 34) each lie adjacent to one another.

7. The semiconductor laser according to one of the preceding claims,
**characterized in that**
the lattice structure (24, 39) is arranged in a plane running parallel to the laser layer (13, 37).

8. The semiconductor laser according to one of the preceding claims,
**characterized in that**
an interaction region (34) is provided in only one end region of the semiconductor substrate (36).

9. The semiconductor laser according to any one of the claims 1 to 7,
**characterized in that**
an interaction region (24, 25) is provided in both end regions of the semiconductor substrate (11).

10. The semiconductor laser according to one of the preceding claims,
**characterized in that**
at least one interaction region contact metallization (43) is applied in at least one interaction region (34), which contact metallization has an electrical contact with the waveguide region (40).

11. The semiconductor laser according to one of the preceding claims,
**characterized in that**
the lattice structure (24) is made of metal, in particular chrome or a chrome alloy.

12. The semiconductor laser according to one of the preceding claims,
**characterized in that**
the lattice structure (39) is formed from the substrate material.

13. The semiconductor laser according to one of the preceding claims,
**characterized in that**
the substrate (11, 36) is formed substantially from indium phosphide.

14. The semiconductor laser according to one of the preceding claims,
**characterized in that**
the lattice structure has two structural regions (24, 39) in at least one interaction region, which structural regions are arranged on both sides of the waveguide region (18, 40).

15. The semiconductor laser according to one of the preceding claims,
**characterized in that**
the lattice structure has a structural region in at least one interaction region, which structural region is arranged along one side of the waveguide region.

16. The semiconductor laser according to one of the preceding claims,
**characterized in that**
the structural regions (24, 39) of the lattice structure are arranged adjacent to lateral flanks (16, 17) of the waveguide region (18, 40).

17. The semiconductor laser according to one of the preceding claims,
**characterized in that**
the flanks of the waveguide region are arranged substantially at right angles to the extension plane of the lattice structure.

18. A method of fabricating a semiconductor laser (32, 33) according to any one of the claims 1 to 17, **characterized by** the process steps:
- fabrication of a complete semiconductor laser structure using an epitaxy method,
- fabrication of a waveguide region (18, 40) through exposure of the semiconductor structure to a material removal procedure to form carrier faces (19, 20) arranged to the side of the waveguide region (18),
- application of the lattice structure (24) to the carrier faces (19, 20) in the region of the interaction regions (25, 26),
- application of an insulating layer (29) in the region of the interaction regions (25, 26).

19. The method according to claim 18,
**characterized in that**
in order to apply a lattice structure made of metal, a lithography method is used with subsequent metallization of the lithographic structure.

20. The method according to claim 18,
**characterized in that**
an ion implantation process is used to apply a lattice structure.

21. The method according to claim 20, **characterized in that**
crystal lattice defects produced by the ion implantation process, particularly crystal lattice defects which are deep in the substrate material, are at least partially healed by means of a healing stage.

22. The method according to claim 20 or 21, **characterized in that**
crystal lattice defects produced by the ion implantation process, particularly crystal lattice defects which are close to the surface, are removed by a material removal process, in particular by an etching process.

23. The method according to one of the claims 18 to 22,
**characterized in that**
a plurality of semiconductor lasers is fabricated in a wafer assembly using the process steps:
- fabrication of a semiconductor wafer by applying an epitaxy structure to a semiconductor substrate,
- fabrication of a ridge-shaped waveguide structure arranged on the surface of the semiconductor laser wafer, said structure having waveguide regions parallel to one another,
- division of the semiconductor wafer into individual semiconductor laser chip units,
- fabrication of one or a plurality of lattice structures on the semiconductor laser chip units.

## Revendications

1. Laser à semi-conducteurs pour générer une onde lumineuse, comportant un substrat à semi-conducteurs (11, 36), une couche laser (13, 37) disposée sur le substrat à semi-conducteurs, une zone de guide d'onde (18, 40) disposée au moins partiellement à proximité de la couche laser et une structure de réseau (24, 39) conçue en forme de bande,
**caractérisé en ce que**
la zone de guide d'onde (18, 40) présente au moins une zone d'amplification (27, 35) pour amplifier l'onde lumineuse, qui est disposée à distance de la structure de réseau (24, 39) et présente au moins une zone d'interaction (25, 26, 34) pour l'interaction entre l'onde lumineuse et la structure d réseau (24, 39), qui est voisine de la structure de réseau
et **caractérisé en ce que**
la couche laser, la zone de guide d'onde et la structure de réseau sont adaptées les unes aux autres de telle sorte que seul un faible couplage entre l'onde lumineuse et la structure de réseau ait lieu avec une constante de couplage K entre l'onde lumineuse et la structure de réseau de K≤30 cm⁻¹, de préférence K≤10 cm⁻¹.

2. Laser à semi-conducteurs selon la revendication 1, **caractérisé en ce que**
une structure de réseau couplée par indice présente dans au moins une zone d'interaction deux zones structurées (24, 39), qui sont disposées des deux côtés de la zone de guide d'onde (18, 40).

3. Laser à semi-conducteurs selon une des revendications précédentes,
**caractérisé en ce que**
la structure de réseau (24, 39) est conçue comme une structure de réseau couplée complexe.

4. Laser à semi-conducteurs selon une des revendications précédentes,
**caractérisé en ce que**
dans la zone d'amplification (27, 35) un contact électrique entre la zone de guide d'onde (18, 40) et une métallisation de contact (31, 42) est réalisé.

5. Laser à semi-conducteurs selon une des revendications précédentes,
**caractérisé en ce que**
à l'extérieur de la zone d'amplification (27, 35) une couche d'isolation électrique (29, 41) entre une métallisation de contact (31, 42, 43) et une partie directement voisine du laser à semi-conducteurs est réalisée.

6. Laser à semi-conducteurs selon une des revendications précédentes,
**caractérisé en ce que**
des zones d'amplification (27, 35) et des zones d'interaction (24, 25, 34) sont situées respectivement voisines les unes des autres.

7. Laser à semi-conducteurs selon une des revendications précédentes,
**caractérisé en ce que**
la structure de réseau (24, 39) est disposée dans un plan s'étendant parallèlement à la couche laser (13, 37).

8. Laser à semi-conducteurs selon une des revendications précédentes,
**caractérisé en ce que**
une zone d'interaction (34) est prévue seulement dans une zone d'extrémité du substrat à semi-conducteurs (36).

9. Laser à semi-conducteurs selon une des revendications 1 à 7,
**caractérisé en ce que**
une zone d'interaction (24, 25) est prévue dans les deux zones d'extrémité du substrat de semiconducteur (11).

10. Laser à semi-conducteurs selon une des revendications précédentes,
**caractérisé en ce que**
dans au moins une zone d'interaction (34) au moins une métallisation de contact de zone d'interaction (43) est appliquée, qui présente un contact électrique avec la zone de guide d'onde (40).

11. Laser à semi-conducteurs selon une des revendications précédentes,
**caractérisé en ce que**
la structure de réseau (24) est fabriquée en métal, notamment en chrome ou un alliage de chrome.

12. Laser à semi-conducteurs selon une des revendications précédentes,
**caractérisé en ce que**
la structure de réseau (39) est formée à partir du matériau de substrat.

13. Laser à semi-conducteurs selon une des revendications précédentes,
**caractérisé en ce que**
le substrat (11, 36) est essentiellement réalisé en InP.

14. Laser à semi-conducteurs selon une des revendications précédentes,
**caractérisé en ce que**
la structure de réseau présente dans au moins une zone d'interaction deux zones structurées (24, 39), qui sont disposées des deux côtés de la zone de guide d'onde (18, 40).

15. Laser à semi-conducteurs selon une des revendications précédentes,
**caractérisé en ce que**
la structure de réseau présente dans au moins une zone d'interaction une zone structurée, qui est disposée le long d'un côté de la zone de guide d'onde.

16. Laser à semi-conducteurs selon une des revendications précédentes,
**caractérisé en ce que**
les zones structurées (24, 39) de la structure de réseau sont disposées en étant contiguës aux flancs latéraux (16, 17) de la zone de guide d'onde (18, 40).

17. Laser à semi-conducteurs selon une des revendications précédentes,
**caractérisé en ce que**
les flancs de la zone de guide d'onde sont disposés essentiellement à angle droit par rapport au plan d'extension de la structure de réseau.

18. Procédé de fabrication d'un laser à semi-conducteurs (32, 33) selon une des revendications 1 à 17,
**caractérisé par** les étapes de procédé consistant à :
- fabriquer une structure complète de laser à semi-conducteurs dans un procédé d'épitaxie,
- fabriquer une zone de guide d'onde (18, 40) par sollicitation de la structure de semi-conducteurs avec un procédé d'enlèvement de matière pour réaliser des surfaces porteuses (19, 20) disposées latéralement à la zone de guide d'onde (18),
- appliquer la structure de réseau (24) sur les surfaces porteuses (19, 20) au niveau des zones d'interaction (25, 26),
- appliquer une couche isolante (29) au niveau des zones d'interaction (25, 26).

19. Procédé selon la revendication 18, **caractérisé en ce que**
pour appliquer une structure de réseau en métal, un procédé de lithographie avec métallisation subséquente de la structure lithographique est employé.

20. Procédé selon la revendication 18, **caractérisé en ce que**
pour appliquer une structure de réseau un processus d'implantation d'ions est employé.

21. Procédé selon la revendication 20, **caractérisé en ce que**
les défauts de réseau cristallin résultant du processus d'implantation d'ions, notamment les défauts de réseau cristallin de trouvant profondément dans le matériau de substrat, sont au moins partiellement recuits thermiquement au moyen d'une étape de recuit thermique.

22. Procédé selon la revendication 20 ou 21, **caractérisé en ce que**
les défauts de réseau cristallin résultant du processus d'implantation d'ions, notamment les défauts de réseau cristallin proches de la surface, sont enlevés par un procédé d'enlèvement de matière, notamment par un processus d'attaque chimique.

23. Procédé selon une des revendications 18 à 22, **caractérisé en ce que**
une pluralité de lasers à semi-conducteurs est fabriquée en ne tranche composite, avec les étapes de procédé consistant à :
- fabriquer une tranche de laser à semi-conducteurs en appliquant une structure d'épitaxie sur un substrat à semi- conducteurs,
- générer une structure de guide d'onde en forme de gradins disposée sur la surface de la tranche de laser à semi-conducteurs avec des zones de guide d'onde parallèles unes aux autres,
- diviser la tranche de laser à semi-conducteurs en unités de puces de laser à semi-conducteurs individuelles,
- générer une ou plusieurs structures de réseau sur les unités de puces de laser à semi-conducteurs.
